# DEMANDE DE BREVET EUROPEEN

(11) **EP 3 855 506 A1**
(43) Date de publication de la demande: **28.07.2021**
(21) Numéro de dépôt: 21151966.5
(22) Date de dépôt: 18.01.2021
(51) Int. Cl.: H01L 29/78, H01L 29/06, H01L 29/40, H01L 21/336

(54) **STRUCTURE DE TRANSISTOR**

(30) Priorité: 23.01.2020 FR 2000669
(71) Demandeur: STMicroelectronics (Rousset) SAS, 13790 Rousset (FR)
(72) Inventeur: GERMANA-CARPINETO, Rosalia, 06600 ANTIBES (FR)
(74) Mandataire: Cabinet Beaumont

(57) **Abrégé**

La présente description concerne un transistor comprenant une région semiconductrice de drain (140) délimitée par une première tranchée, et, dans la première tranchée, un premier élément électriquement conducteur (170) relié électriquement à un nœud (145) d'application d'un potentiel plus proche d'un potentiel de drain du transistor que d'un potentiel de source du transistor.

## Description

### Domaine technique

La présente description concerne de façon générale les dispositifs électroniques, et plus particulièrement des transistors.

### Technique antérieure

Dans certains dispositifs électroniques, des transistors à effet de champ sont utilisés à un état non passant pour bloquer des tensions élevées, typiquement supérieures à 10 V, par exemple de l'ordre de 40 V, voire supérieures à 100 V. Plus le transistor est petit et/ou plus la tension bloquée à l'état non passant est élevée, plus la résistance du transistor à l'état passant est élevée.

### Résumé de l'invention

Il existe un besoin d'améliorer, dans les transistors, le compromis entre la résistance à l'état passant, les dimensions, et la tension bloquée à l'état non passant.

Un mode de réalisation pallie tout ou partie des inconvénients des transistors connus.

Un mode de réalisation permet de réduire la résistance à l'état passant et/ou de réduire la surface occupée et/ou d'augmenter la tension bloquée.

Un mode de réalisation prévoit un transistor comprenant une région semiconductrice de drain délimitée par une première tranchée, et, dans la première tranchée, un premier élément électriquement conducteur relié électriquement à un nœud d'application d'un potentiel plus proche d'un potentiel de drain du transistor que d'un potentiel de source du transistor.

Selon un mode de réalisation, le transistor comprend une grille située dans une deuxième tranchée colinéaire à la première tranchée.

Selon un mode de réalisation, le transistor comprend, entre la grille et le premier élément conducteur, une région isolante d'épaisseur supérieure à une épaisseur d'isolant de grille du transistor et, de préférence, une partie de la région semiconductrice de drain.

Selon un mode de réalisation, le transistor comprend un deuxième élément conducteur situé dans la deuxième tranchée.

Selon un mode de réalisation, la première tranchée s'étend dans un substrat à partir d'une face du substrat, une prise de contact de drain du transistor et une zone de formation de canal du transistor étant situées du côté de ladite face du substrat.

Selon un mode de réalisation, la zone de formation de canal est reliée électriquement à un nœud d'application du potentiel de source du transistor.

Selon un mode de réalisation, le transistor comprend une région semiconductrice de source, délimitée par la deuxième tranchée et en contact avec la zone de formation de canal du côté de la zone de formation de canal opposé à la région semiconductrice de drain.

Selon un mode de réalisation, la première tranchée s'étend dans une région du substrat située en partie sous la région semiconductrice de drain.

Selon un mode de réalisation, la zone de formation de canal est une partie de ladite région du substrat.

Selon un mode de réalisation, ladite région du substrat est isolée, par un caisson enterré, d'une autre région du substrat située sous le caisson enterré, le caisson enterré étant de préférence entièrement situé à une profondeur supérieure à celle du fond de la première tranchée.

Selon un mode de réalisation, la région semiconductrice de drain est délimitée, d'un côté opposé à celui de la première tranchée, par une tranchée supplémentaire, et un élément électriquement conducteur supplémentaire est situé dans la tranchée supplémentaire.

Selon un mode de réalisation, des extrémités de la première tranchée et de la tranchée supplémentaire sont alignées dans une direction de largeur des tranchées.

Selon un mode de réalisation, ladite région semiconductrice de drain présente, dans une direction parallèle à la première tranchée, un niveau de dopage décroissant à partir de la prise de contact.

Un mode de réalisation prévoit un dispositif électronique comprenant un ou plusieurs transistors tels que définis ci-dessus.

Selon un mode de réalisation, le dispositif est monolithique et comprend en outre des transistors de type CMOS et/ou un transistor vertical comprenant des tranchées de même profondeur que la première tranchée.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, une vue de dessus 1A, et des vues en coupe 1B, 1C, 1D et 1E d'un exemple de mode de réalisation d'un dispositif comprenant un transistor ;
la figure 2 représente, de manière partielle et schématique, une vue en perspective du dispositif de la figure 1 ;
la figure 3 représente, de manière partielle et schématique, une vue de dessus 3A, et des vues en coupe 3B, 3C, 3D et 3E, d'une étape d'un exemple de procédé de fabrication du dispositif de la figure 1 ; et
la figure 4 représente, de manière partielle et schématique, une vue de dessus 4A, et des vues en coupe 4B, 4C, 4D et 4E, d'une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des étapes de fabrication de masques, des étapes de dopage, et de fabrication de bornes connectées électriquement à des zones dopées ne sont pas détaillées, les modes de réalisation décrits étant compatibles avec des telles étapes usuelles.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe.

Sauf précision contraire, les expressions "environ", "approximativement", "sensiblement", et "de l'ordre de" signifient à 10 % près, de préférence à 5 % près.

Sauf précision contraire, les adjectifs numéraux ordinaux, tels que "premier", "deuxième", etc., sont utilisés seulement pour distinguer des éléments entre eux. En particulier, ces adjectifs ne limitent pas les modes de réalisation décrits à un ordre particulier de ces éléments.

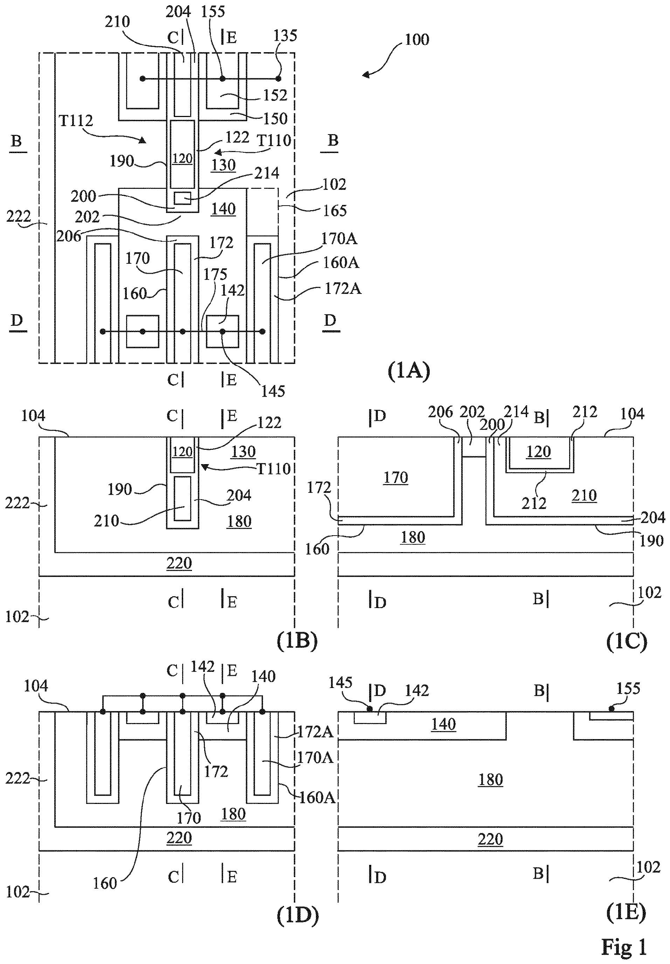

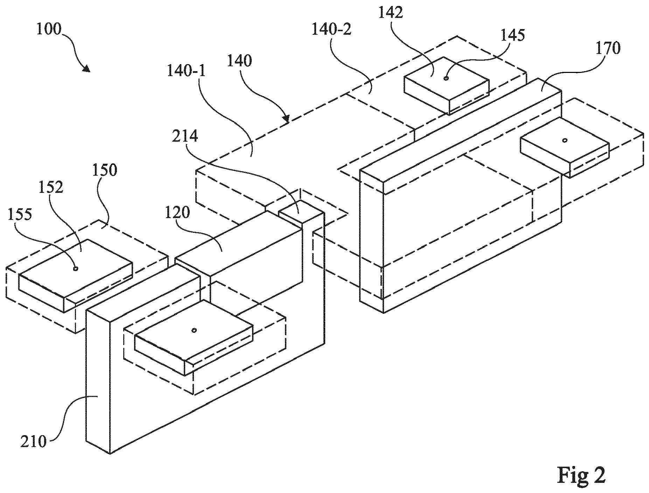

La figure 1 représente, de manière partielle et schématique, une vue de dessus 1A, et des vues en coupe 1B, 1C, 1D, et 1E d'un exemple de mode de réalisation d'un dispositif 100 comprenant un transistor. Les vues en coupe 1B, 1C, 1D, et 1E ont pour plans de coupe respectifs des plans B-B, C-C, D-D et E-E. Les vues 1A, 1B et 1C sont en correspondance dans la direction verticale des figures, et les vues 1B et 1C, respectivement 1D et 1E, sont en correspondance dans la direction horizontale des figures. La figure 2 représente une vue en perspective schématique et partielle du dispositif 100. Notamment, des isolants électriques, un substrat semiconducteur et un caisson enterré ne sont pas représentés en figure 2.

Le dispositif 100 comprend typiquement une puce électronique de circuit intégré, définie par un substrat semiconducteur 102 et des éléments, tels que des composants électroniques, situés dans et sur le substrat 102. Le dispositif 100 est de préférence monolithique. Par dispositif monolithique, on entend que tous les circuits du dispositif sont intégrés dans et sur un même substrat ou support, typiquement dans et sur une même portion de tranche (en anglais "wafer") semiconductrice. Un tel dispositif, ou circuit intégré, monolithique est, de préférence, situé dans un boîtier de circuit intégré. Par boîtier de circuit intégré, on entend un ensemble, de préférence étanche, d'où sortent des plages de connexion ou des broches de connexion à des circuits électroniques extérieurs au boîtier, par exemple à un circuit imprimé, PCB (en anglais "Printed Circuit Board").

Dans un exemple, le substrat 102 est constitué par une portion de tranche semiconductrice, par exemple une tranche de silicium. Dans un autre exemple, le substrat 102 est constitué par une couche située sur la surface d'une portion de tranche semiconductrice, par exemple une couche épitaxiée sur la tranche semiconductrice. De préférence, le substrat 102 est monocristallin. A titre d'exemple, le substrat 102 est dopé de type N, par exemple à un niveau de dopage compris entre 2*10¹⁶ et 4*10¹⁶ atomes/cm³. Dans les modes de réalisation décrits, les types de conductivité N et P, ou types de dopage, peuvent être échangés. Des fonctionnements similaires à ceux décrits sont alors obtenus en échangeant les signes des tensions dans le dispositif 100.

Parmi les composants électroniques, le dispositif 100 comprend un ou plusieurs transistors. En particulier, le dispositif 100 comprend un transistor T110, ou plusieurs transistors T110 connectés électriquement en parallèle. Les transistors T110 sont de préférence de même type, par exemple similaires ou identiques à des tolérances de fabrication près. Un transistor T110 est représenté en figures 1 et 2. Dans l'exemple d'un substrat 102 dopé de type N, le transistor T110 est préférentiellement à canal P, autrement dit, le transistor T110 est à canal de type de conductivité opposé à celui du substrat 102.

Le transistor T110 comprend une grille 120 et une zone de formation de canal 130, séparées par un isolant de grille 122. La grille 120 comprend au moins un conducteur électrique tel que, par exemple, un métal et/ou du silicium polycristallin dopé. L'isolant de grille 122 est en contact avec la zone de formation de canal 130 et avec au moins un conducteur électrique de la grille 120. L'isolant de grille 122 est typiquement constitué d'une ou plusieurs couches diélectriques, par exemple l'isolant de grille est constitué d'une couche d'oxyde de silicium. L'épaisseur de l'isolant de grille 122 est typiquement inférieure à 15 nm, de préférence comprise entre 5 nm et 40 nm.

D'un côté de la zone de formation de canal 130, le transistor T110 comprend une région semiconductrice 140, dopée de type P dans cet exemple. La région semiconductrice 140 est en contact avec la zone de formation de canal 130. La région semiconductrice 140 résulte par exemple d'une ou plusieurs étapes de dopage d'une partie du substrat 102. La région semiconductrice 140 est en contact avec une zone dopée 142 plus fortement dopée de même type que la région 140. La zone dopée 142 forme une prise de contact électrique avec la région dopée semiconductrice 140. Plus précisément, la prise de contact 142 forme une connexion électrique entre la région dopée semiconductrice 140 et un conducteur 145 définissant une borne de drain du transistor T110. La région semiconductrice 140 est alors dite région de drain.

D'un côté de la zone de formation de canal 130 opposé à la région de drain 140, le transistor T110 comprend une région semiconductrice 150 dopée de même type de conductivité que la région de drain 140 (ici de type P). La région semiconductrice 150 est en contact avec la zone de formation de canal 130. La région semiconductrice 150 résulte par exemple d'une ou plusieurs étapes de dopage d'une partie du substrat 102. La région semiconductrice 150 est en contact avec une zone dopée 152 plus fortement dopée de même type que la région 150. La prise de contact 152 forme une prise de contact électrique avec la région semiconductrice 150. Plus précisément, la prise de contact 152 forme une connexion électrique entre la région dopée semiconductrice 150 et un conducteur 155 définissant une borne de source du transistor T110. La région semiconductrice 150 est alors dite région de source.

Le transistor T110 défini par les éléments décrits ci-dessus constitue ainsi un transistor à effet de champ, c'est-à-dire un composant électronique susceptible, en fonction d'une tension de commande appliquée entre la grille 120 et la borne de source 155, de former, dans la zone de formation de canal, un canal conducteur connectant électriquement les régions de drain et de source.

De préférence, les prises de contact 142 et 152 sont constituées de parties dopées respectives du substrat 102 ayant des niveaux de dopage élevés, c'est-à-dire supérieurs à 5*10¹⁸ atomes/cm³, de préférence supérieurs à 10¹⁹ atomes/cm³. Le niveau de dopage de la zone de formation de canal 130 est de préférence inférieur à 2*10¹⁶ atomes/cm³, plus préférentiellement inférieur à 5*10¹⁵ atomes/cm³. De préférence, les régions de drain 140 et de source 150 ont des niveaux de dopage faibles, c'est-à-dire inférieurs à 2*10¹⁷ atomes/cm³. Ce niveau de dopage est toutefois, de préférence, supérieur à 5*10¹⁶ atomes/cm³.

Dans les modes de réalisation décrits, le transistor T110 comprend en outre une première tranchée 160. La tranchée 160 s'étend dans le substrat 102 à partir d'une face 104 dite face avant du substrat 102 (face avant dans l'orientation de la vue 1A, et face supérieure dans les orientations des vues 1B à 1E). De préférence, la profondeur de la tranchée 160 est comprise entre 2 µm et 3 µm. De préférence, la tranchée 160 délimite une partie de la région de drain 140, c'est-à-dire qu'au moins une partie d'un bord de la région de drain 140 est constituée par une partie d'une paroi de la tranchée 160. Dans l'exemple représenté, l'ensemble de la tranchée 160 délimite la région de drain 140. De préférence, la tranchée 160 s'étend parallèlement à la face avant 104 dans une direction principale ou longitudinale de la tranchée. A titre d'exemple, la tranchée 160 présente, dans une direction transversale parallèle à la face avant 104, une largeur constante comprise entre 100 et 500 nm.

De préférence, au moins une partie de la région de drain 140 s'étend parallèlement au bord de la première tranchée 160 à partir de la prise de contact de drain 142 en direction de la zone de formation de canal 130. Cette partie de la région de drain 140 est dite région de dérive. A titre d'exemple, la distance séparant la zone de formation de canal 130 de la prise de contact 142 est comprise entre 1 et 5 µm, préférentiellement entre 2 et 4 µm.

A l'état bloqué du transistor T110, la région de dérive, du fait de son faible niveau de dopage, bloque une tension élevée, telle que mentionnée en préambule, entre la zone de formation de canal 130 et la prise de contact 142. A l'état passant du transistor T110, un courant traversant le transistor T110 circule dans la région de dérive, de la zone de formation de canal 130 à la prise de contact 142.

Le transistor T110 comprend en outre un premier élément conducteur 170 situé dans la première tranchée 160. L'élément conducteur 170 est situé en vis-à-vis d'au moins une partie de la région de drain 140, c'est-à-dire qu'au moins une partie de l'élément conducteur 170 est située dans une portion de la tranchée 160, cette portion délimitant au moins une partie de la région de drain 140. Plus précisément, l'élément conducteur 170 est situé en vis-à-vis d'au moins une partie de la région de dérive. De préférence, l'élément conducteur 170 est situé contre une couche électriquement isolante 172 située dans la tranchée 160 contre au moins une partie de la région de drain 140, et, en particulier, contre au moins une partie de la région de dérive. La couche isolante 172 sépare alors l'élément conducteur 170 de la région de dérive. La distance entre l'élément conducteur 170 et la région de drain 140, égale à l'épaisseur de la couche isolante 172, est par exemple comprise entre 100 nm et 210 nm, de préférence, comprise entre 120 nm et 180 nm. La couche isolante 172 a de préférence une épaisseur supérieure à celle de l'isolant de grille 122. A titre d'exemple, la couche isolante 172 est en oxyde de silicium ou en nitrure de silicium.

De préférence, le premier élément conducteur 170 est constitué par un mur conducteur situé dans une partie centrale de la première tranchée 160. Le mur est allongé dans la même direction que la tranchée 160. Le mur s'étend dans le substrat 102 orthogonalement à la face avant 104. A titre d'exemple, le mur comprend, de préférence est constitué par, un matériau métallique ou, préférentiellement, du silicium polycristallin dopé. La largeur du mur conducteur, prise dans la direction de largeur de la tranchée 160, est par exemple comprise entre 30 nm et 210 nm.

Le premier élément conducteur 170 est relié électriquement, de préférence connecté électriquement, à un nœud d'application d'un potentiel plus proche d'un potentiel de drain du transistor T110 que d'un potentiel de source du transistor T110. De préférence, le potentiel appliqué à ce nœud est approximativement égal, plus préférentiellement égal, au potentiel de drain. Encore plus préférentiellement, ce nœud est défini par la borne de drain 145. Autrement dit, le transistor T110 comprend alors une liaison électrique 175, de préférence une connexion électrique, entre l'élément conducteur 170 et la zone de contact de drain 145.

De ce fait, en fonctionnement, l'élément conducteur 170 est polarisé à un potentiel plus proche du potentiel de drain du transistor T110 que du potentiel de source du transistor T110. Dans l'exemple où le transistor T110 est à canal P, le potentiel appliqué à l'élément conducteur 170 est préférentiellement inférieur ou égal à celui du drain. Dans cet exemple, pour des potentiels de source, de drain et de grille positifs par rapport à un potentiel de référence tel que celui d'une masse, l'élément conducteur 170 peut optionnellement être relié ou connecté à la masse au lieu d'être connecté à la borne de drain 145.

A l'état bloqué du transistor T110, le premier élément conducteur 170 écrante une partie du champ électrique dû à la tension entre la zone de formation de canal 130 et la prise de contact 142. Le champ électrique dans la région de dérive est donc plus réduit que si l'élément conducteur 170 n'était pas prévu. Ceci permet, par rapport à un transistor qui serait dépourvu de l'élément conducteur 170, d'augmenter le niveau de dopage de la région de dérive, et donc d'augmenter la conductivité électrique de la région de dérive à l'état passant, sans réduire la tension maximum que le transistor peut bloquer. On améliore ainsi le compromis entre la conductance du transistor à l'état passant et la tension maximum que le transistor peut bloquer.

Selon un mode de réalisation, la prise de contact de drain 142 et la zone de formation de canal 130, et, préférentiellement, la prise de contact de source 152, sont situés du côté de la face avant 104, c'est-à-dire qu'ils présentent, du côté de la face avant, chacun une face non recouverte par une partie du substrat. De préférence, la zone de formation de canal 130 peut être en contact électrique avec une prise de contact non représentée, formant une connexion électrique entre la zone de formation de canal 130 et une borne 135. Les bornes 135, 145 et 155 peuvent être définies par des conducteurs situés sur les prises de contact, par exemple des vias traversant une couche isolante (non représentée) recouvrant le dispositif 100. Des connections permettant de relier électriquement le transistor T110 à d'autres composants du dispositif ou à un dispositif extérieur, sont alors plus faciles à réaliser que dans des exemples où la prise de contact 142 est située côté face arrière (face du substrat 102 opposée à la face avant 104).

De préférence, la prise de contact de source 152 est reliée électriquement, de préférence connectée, à la zone de formation de canal 130. Plus préférentiellement, ceci est obtenu par une liaison, de préférence une connexion, entre les bornes 155 et 135. Il en résulte que la formation du canal conducteur entre les régions de drain 140 et de source 150 est fonction de la tension entre la borne de source 155 et la grille 120 du transistor T110.

Selon un mode de réalisation, la région de drain 140 est située sur une région 180 du substrat 102. La région 180 est, de préférence, de même type de dopage, ici de type N, que le substrat 102, et présente le même niveau de dopage que le niveau de dopage présenté par le substrat 102 avant formation des régions dopées de drain 140 et de source 150 et des prises de contact 142 et 152. Autrement dit, la région 180 est alors une partie du substrat 102 qui, après formation du substrat 102, n'a pas été dopée ou volontairement dopée.

En particulier, dans le cas où le transistor T110 est à canal de conductivité opposé à celui du substrat 102, la région 180 est située en partie sous la région de drain 140. Dans ce cas, de préférence, la région 180 comprend également la zone de formation de canal 130. Dans une variante, on peut former le transistor T110 à canal de conductivité opposé à celui du substrat 102 dans et sur une région dopée s'étendant dans le substrat 102 plus profondément que le transistor T110 et de type de conductivité opposé à celui du substrat 102. Par rapport à cette variante, le fait de prévoir que la région 180 comprenne la zone de formation de canal 130 permet d'obtenir plus facilement la région de canal et la région de drain, notamment le niveau de dopage souhaité de la région de canal.

Selon un mode de réalisation, la première tranchée 160 s'étend, à partir de la face avant 104, jusqu'à une profondeur supérieure à celle de la région de drain 140. Par exemple, la région de drain 140 s'étend, à partir de la face avant 104, jusqu'à une profondeur comprise entre 0,5 µm et 1 µm. La profondeur de la tranchée 160 est par exemple supérieure de 1 µm à 2 µm à celle de la région de drain. Plus particulièrement, la tranchée 160 s'étend dans la région 180.

On aurait pu penser former, sur un substrat tel que le substrat 102, un transistor à canal de type de conductivité opposé à celui du substrat, sans prévoir d'élément conducteur tel que l'élément conducteur 170. Par rapport à un tel transistor, le fait de prévoir l'élément conducteur 170 relié à un nœud d'application d'un potentiel plus proche de celui du drain que de celui de la source permet de limiter, à l'état bloqué du transistor T110, le champ électrique supporté par la jonction PN entre la région de drain 140 et la région 180 du substrat 102. Plus particulièrement, la polarisation de l'élément conducteur 170 à un potentiel sensiblement égal, de préférence égal, à celui du drain permet de minimiser le champ électrique supporté par cette jonction PN. Ceci augmente la tension maximum que le transistor T110 peut bloquer.

Pour augmenter la tension maximum qu'un transistor peut bloquer, on pourrait penser diminuer le niveau de dopage de sa région de drain. Cependant, ceci augmenterait la résistance de la région de dérive, et donc la résistance du transistor à l'état passant. L'élément conducteur 170 polarisé à un potentiel plus proche de celui du drain que de celui de la source permet d'augmenter la tension maximum bloquée par le transistor T110 sans réduire le niveau de dopage de la région de dérive, donc sans augmenter la résistance du transistor à l'état passant.

Ainsi, on aurait pu prévoir un transistor dépourvu d'élément conducteur tel que l'élément conducteur 170, ou comprenant un élément conducteur semblable à l'élément conducteur 170 mais polarisé à un potentiel relativement proche de celui de la source, par exemple au potentiel de la source. Par rapport à un tel transistor, le fait de prévoir l'élément conducteur 170 polarisé à un potentiel relativement proche de celui du drain, par exemple au potentiel du drain, améliore le compromis entre la conductance du transistor à l'état passant et la tension maximum blocable par le transistor.

Selon un mode de réalisation, la région de drain 140 est délimitée, sur un côté opposé à la première tranchée 160, par une tranchée supplémentaire 160A. La région de drain 140 est alors située entre les tranchées 160 et 160A. La tranchée supplémentaire 160A est parallèle à la première tranchée 160, c'est-à-dire que les tranchées 160 et 160A ont la même direction d'allongement. Plus préférentiellement, la tranchée supplémentaire 160A contient des mêmes éléments que la première tranchée 160, disposés symétriquement par rapport à la région de drain 140, à savoir, un élément conducteur supplémentaire 170A symétrique du premier élément conducteur 170, situé en vis-à-vis d'au moins une partie de la région de dérive, et séparé de la région de drain 140 par une couche isolante 172A. Ainsi, de préférence, les éléments conducteurs 170 et 170A pénètrent tous deux dans la région 180 du substrat 102. L'élément conducteur supplémentaire 170A est également relié, de préférence connecté, à un nœud d'application du potentiel de drain, par exemple à la borne de drain 145.

L'élément conducteur supplémentaire 170A permet une amélioration supplémentaire du compromis entre la conductance du transistor à l'état passant et la tension maximum blocable par le transistor.

Dans l'exemple de tranchée supplémentaire 160A décrit ci-dessus, la tranchée supplémentaire 160A a son extrémité alignée, dans la direction de largeur des tranchées, avec l'extrémité de la première tranchée 160. Cependant, dans une variante représentée par des pointillés 165 sur la vue 1A, la tranchée supplémentaire 160A peut s'étendre, à partir de sa partie située en vis-à-vis de la prise de contact 142 et en se rapprochant de la zone de formation de canal 130, plus loin que la première tranchée 160. Par exemple, la tranchée supplémentaire 160A délimite l'intégralité du bord de la région de drain 140 opposé à la première tranchée 160. Dans une variante, la première tranchée 160 est omise, et on prévoit seulement la tranchée supplémentaire 160A.

Selon un mode de réalisation, la grille 120 est située dans une deuxième tranchée 190. De préférence, les tranchées 160 et 190 sont colinéaires selon une même direction d'allongement. Plus préférentiellement, les tranchées 160 et 190 ont une même largeur et une même profondeur. La grille 120 a préférentiellement une forme allongée dans la direction longitudinale de la tranchée 190. De préférence, la grille 120 est située dans la tranchée 190 du côté de la face avant 104 (c'est-à-dire en partie supérieure de la tranchée 190 dans les vues 1B, 1C, 1D et 1E). Par exemple, la grille 120 affleure la face avant 104 du substrat 102.

Ainsi, la deuxième tranchée 190 délimite la zone de formation de canal 130. Plus précisément, la zone de formation de canal a alors une face latérale constituée par une partie de la paroi de la tranchée 190. L'isolant de grille 122 recouvre cette partie de la paroi de la tranchée 190. La zone de formation de canal 130 correspond, de préférence, à une partie de la région 180 du substrat 102 située en vis-à-vis de la grille 120.

Du fait que la grille 120 est dans la deuxième tranchée 190, le canal conducteur qui se forme à l'état passant est située contre la paroi de la tranchée 190. Par rapport à une variante dans laquelle la grille 120 est disposée sur la zone de formation de canal 130 (par exemple repose sur la face avant 104), on évite que le canal de conduction ait comme largeur celle de la tranchée 190. On peut alors réduire la largeur de tranchée sans réduire la largeur du canal de conduction, et donc sans augmenter la résistance du transistor à l'état passant. Ainsi, la surface occupée par le transistor T110 est, pour un même courant et une même résistance à l'état passant, plus réduite que celle d'un transistor ayant sa grille située sur la zone de canal.

Selon un mode de réalisation, le transistor T110 comprend, entre la grille 120 et le premier élément conducteur 170, une région isolante 200. La région isolante 200 a, dans la direction longitudinale de la tranchée 190, une épaisseur supérieure à celle de l'isolant de grille 122. Par exemple, l'épaisseur de la région isolante 200 est égale à celle de la couche isolante 172 recouvrant les parois de la première tranchée 160. La région isolante 200 est, dans l'exemple représenté, formée d'une portion d'une couche isolante 204 recouvrant les parois de la deuxième tranchée 190. La couche isolante 204 de la deuxième tranchée 190 peut avoir la même épaisseur et être dans les mêmes matériaux que la couche isolante 172 de la première tranchée 160.

Lorsque le transistor T110 est à l'état bloqué, la tension entre la grille 120 et la borne de drain 145 se retrouve entre la grille 120 et le premier élément conducteur 170. La région isolante 200, d'épaisseur supérieure à celle de l'isolant de grille 122 et située entre la grille 120 et le premier élément conducteur 170, évite le risque de claquage que présenterait un isolant d'épaisseur par exemple de l'ordre de celle de l'isolant de grille 122. Pour cela, l'épaisseur de la région isolante 200 est prévue pour résister aux tensions élevées définies ci-dessus. Par exemple cette épaisseur est comprise entre 100 nm et 210 nm, de préférence, comprise entre 120 nm et 180 nm. A titre d'exemple, la région isolante 200, et, de préférence, la couche isolante 204 sont en oxyde de silicium ou en nitrure de silicium.

De préférence, on prévoit en outre, entre la grille 120 et le premier élément conducteur 170, une région semiconductrice 202, dopée de type P dans l'exemple représenté. Autrement dit, la région semiconductrice 202 est du même type de conductivité que la région de drain 140. La région semiconductrice 202 peut être obtenue dans une même étape de dopage que la région de drain 140, et peut présenter un même niveau de dopage. Autrement dit, la région conductrice 202 constitue alors une partie de la région de drain 140. A l'état bloqué du transistor, la région semiconductrice 202 est déplétée et participe ainsi à l'isolation électrique entre la grille 120 et le premier élément conducteur 170.

Plus préférentiellement, on prévoit également, entre la grille 120 et le premier élément conducteur 170, une autre région isolante 206, plus préférentiellement formée par une partie de la couche isolante 172 recouvrant les parois de la première tranchée 160. Dans une variante, les tranchées 160 et 190 sont deux portions d'une même tranchée, et la région isolante 200 est un élément isolant situé dans la tranchée. Cependant, par rapport à cette variante, le fait de prévoir deux régions isolantes 200 et 206 recouvrant les parois des deux tranchées 160 et 190 distinctes, permet de faciliter la réalisation de l'isolation électrique.

Selon un mode de réalisation, la région de drain 140 présente, à partir de la prise de contact 142, des niveaux de dopage décroissants. Dans l'exemple représenté, la région de drain 140 comprend deux sous-régions 140-1 et 140-2 (représentées uniquement en figure 2). La sous-région 140-1 est en contact avec la zone de formation de canal.

Dans un exemple préféré, la sous-région 140-2 sépare la sous-région 140-1 de la prise de contact 142. La sous-région 140-2 s'étend à partir de la prise de contact 142, par exemple est située sous et autour de la prise de contact 142. A partir de la prise de contact 142, une partie de la sous-région 140-2 s'étend vers la zone de formation de canal 130 sur une distance par exemple comprise entre un tiers et deux tiers, de préférence sensiblement la moitié, de la distance entre la prise de contact 142 et la zone de formation de canal 130. Cette partie de la sous-région 140-2 s'étend à partir de la prise de contact 142 sur une distance par exemple comprise entre 0,5 µm et 1,5 µm, de préférence de l'ordre de 1 µm. Le niveau de dopage de la sous-région 140-2 est compris entre celui de la région 140-1 et celui de la prise de contact 142. Le niveau de dopage de la sous-région 140-2 peut-être compris entre 10¹⁷ et 10¹⁸ atomes/cm³.

Cet exemple préféré n'est pas limitatif, la région de drain 140 pouvant comprendre, ou être constituée par, un nombre N de sous-régions semiconductrices 140-i, l'indice i étant compris entre 1 et N. La sous-région 140-N s'étend à partir de la prise de contact 142. Les sous-régions sont placées selon l'indice i décroissant à partir de la prise de contact 142, le niveau de dopage des sous-régions 140-i est une fonction croissante de l'indice i. En variante, la région semiconductrice 140 peut présenter un gradient de niveau de dopage à partir de la prise de contact 142.

Les sous-régions 140-i pour i différent de 1, ou la sous-région à gradient de dopage, constituent une zone à niveau de dopage intermédiaire entre celui de la sous-région 140-1 et celui de la prise de contact 142. Le fait que le niveau de dopage de la région de drain 140 soit décroissant à partir de la prise de contact 142, permet une amélioration supplémentaire du compromis entre la conductance du transistor à l'état passant et la tension maximum blocable par le transistor.

Selon un mode de réalisation, la deuxième tranchée 190 s'étend en direction de la région de source 150 et délimite au moins une partie de la région de source 150. Le transistor T110 comprend alors un deuxième élément conducteur 210 dans la tranchée 190, situé en vis-à-vis d'au moins une partie de la région de source 150. Le deuxième élément conducteur 210 est séparé des parois de la tranchée 190 par la couche isolante 204. Le deuxième élément conducteur 210 est, de préférence, colinéaire avec le premier élément conducteur 170. Plus préférentiellement, le deuxième élément conducteur 210 a, dans un plan orthogonal à celui de la tranchée 190 et sur au moins une partie de la longueur de la tranchée 190, une section de même forme et dimensions que celles de la section du premier élément conducteur 170. Dans le cas où la grille 120 est située dans la tranchée 190, le deuxième élément conducteur 210 est, de préférence, en partie situé sous la grille 120. Dans ce cas, l'élément conducteur 210 et la grille 120 sont préférentiellement séparés par un isolant 212. L'isolant 212 a alors, de préférence, une épaisseur égale ou sensiblement égale à celle de l'isolant de grille 122.

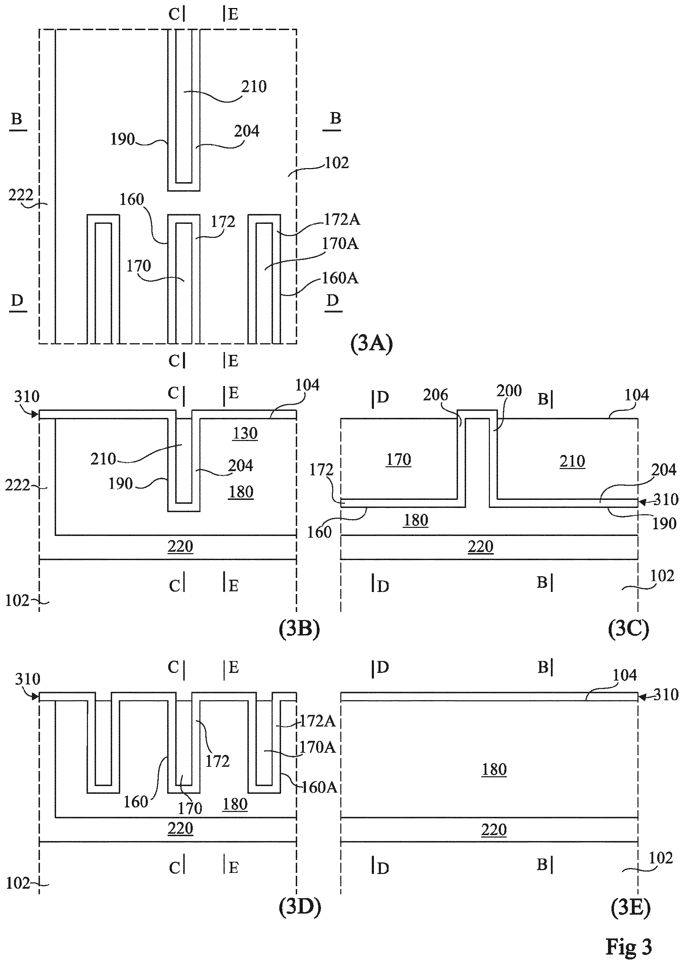

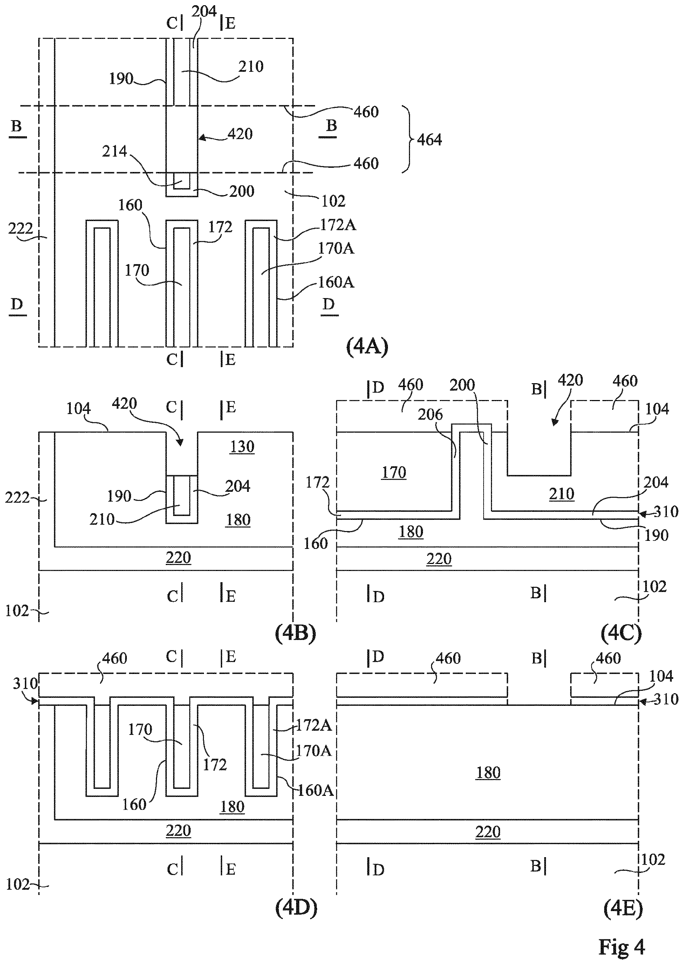

De préférence, le deuxième élément conducteur 210 comprend en outre une portion 214 située entre la grille 120 et la région isolante 200. Par rapport à une variante dans laquelle cette portion est omise, ceci permet, lorsque la grille 120 est formée après la région isolante 200, de résoudre divers problèmes d'alignement de la grille 120 avec le bord de la région isolante 200. Par exemple, ces problèmes d'alignement sont évités lorsque le transistor T110 est réalisé selon le procédé décrit ci-après en relation avec les figures 3 et 4.

Selon un avantage, on peut prévoir en outre, dans le dispositif 100, des transistors dits transistors verticaux, non représentés. Dans de tels transistors, à l'état passant, le courant circule verticalement (c'est-à-dire orthogonalement à la face avant du substrat) entre une zone de formation de canal située du côté de la face avant et une prise de contact de drain située sur la face arrière. Le transistor vertical peut comprendre des tranchées comprenant des éléments conducteurs destinés à écranter le champ électrique dans une région de dérive lorsque le transistor vertical est à l'état bloqué. De préférence, ces tranchées des transistors verticaux ont la même profondeur que la première tranchée 160 et l'éventuelle deuxième tranchée 190. De préférence, les tranchées des transistors verticaux sont répétées au même pas que celui qui sépare la première tranchée 160 et de la tranchée supplémentaire 160A. De préférence, les tranchées des transistors verticaux ont la même orientation que la ou les tranchées du transistor T110. Pour obtenir, dans le même dispositif, le transistor T110 et les transistors verticaux, des étapes de fabrication du transistor T110 et des transistors verticaux peuvent alors être simultanées. Un dispositif comprenant, sur un même substrat ou une même tranche semiconductrice, à la fois des transistors verticaux et des transistors tel que le transistor T110 est alors particulièrement simple à fabriquer.

Selon un mode de réalisation, le dispositif 100 comprend, outre le transistor T110, un transistor T112 symétrique du transistor T110 par rapport à la première tranchée 160, à des tolérances de fabrication près. La première tranchée 160 et le premier élément conducteur 170 sont alors communs aux deux transistors T110 et T112. La grille 120 peut également être commune aux deux transistors T110 et T112, ainsi que les éléments situés entre la grille commune 120 et le premier élément conducteur 170. L'éventuelle deuxième tranchée 190 et le deuxième élément conducteur 210 peuvent eux aussi être communs aux deux transistors T110 et T112.

Selon un mode de réalisation, le dispositif 100 comprend un caisson 220 enterré dans le substrat 102. Autrement dit, le caisson enterré 220 a un type de conductivité (ici de type P) opposé à celui du substrat 102 (ici de type N), et est situé sous la région 108 du substrat 102 et sur une autre région du substrat 102. Une région dopée 222 de même type de conductivité que le caisson enterré 220 s'étend à partir de la périphérie du caisson enterré 220 jusqu'à la face avant 104. Seul un côté de la région dopée 222 est représenté. La région dopée 222 et le caisson enterré 220 sont polarisables ensemble. Dans le cas où le substrat 102 est de type N, le potentiel de polarisation du caisson enterré 220 et de la région dopée 222 est inférieur à celui de la région 180 du substrat 102. Par exemple, la région dopée 222 et le caisson enterré 220 sont polarisés à un potentiel inférieur, ou égal, à celui du drain, de préférence au potentiel de la masse. La région dopée 222 et le caisson enterré 220 permettent ainsi d'isoler électriquement la région 180 par rapport au reste du substrat 102. Le transistor T110 est alors isolé d'autres composants du dispositif 100, par exemple d'autres transistors.

Ainsi, selon un avantage, on peut prévoir en outre dans le dispositif 100, des transistors de type Métal-Oxide-Semiconducteur Complémentaires CMOS (en anglais "Complementary Metal Oxide Semiconductor"). On note que le type Métal-Oxyde-Semiconducteur, MOS, désignait, à l'origine de cette dénomination, des transistors ayant leur grille en métal et leur isolant de grille en oxyde. Cependant, le type MOS est maintenant, suite au développement de ce type de transistor, entendu comme englobant des transistors à effet de champ dont la grille est en n'importe quel conducteur électrique, et dont l'isolant de grille est en n'importe quel diélectrique ou isolant électrique. La fabrication du transistor T110 peut comprendre des étapes communes avec la fabrication des transistors CMOS. Notamment, les régions dopées de drain 140 et de source 150, et les prises de contact 142 et 152, peuvent être formées en même temps que des régions dopées et des prises de contact des transistors CMOS. Le caisson enterré 220 peut également être formé en même temps que d'éventuels autres caissons enterrés sous les transistors CMOS.

De préférence, la ou les tranchées du transistor T110 n'atteignent pas le caisson enterré 220. On évite ainsi qu'un canal conducteur risque de se créer dans la région 180 le long des faces de la première tranchée 160 en vis-à-vis du premier élément conducteur 170. Un tel canal conducteur risquerait de provoquer un courant parasite entre la région de drain 140 et le caisson enterré 220.

De préférence, le dispositif 100 comprend plusieurs transistors T110 et T112, plus préférentiellement répétés en matrice. Ainsi, les transistors sont répétés dans une première direction parallèle à la face avant 104 et dans une deuxième direction parallèle à la face avant 104 et orthogonale à la première direction. L'éventuel caisson enterré 220 est, de préférence, commun aux transistors T110 et/ou T112.

Dans un exemple préféré, les bornes de drain 145 des transistors T110 et T112 de la matrice sont connectées ensemble, les bornes de source 155 des transistors T110 et T112 de la matrice sont connectées ensemble, et les grilles 120 communes à chaque paire de transistors T110/T112 de la matrice sont connectées ensemble. Ainsi, les transistors T110 et/ou T112 sont électriquement en parallèle et sont commandés en parallèle, ce qui permet de faire passer par l'association des transistors en parallèle des courants élevés, c'est-à-dire de plus de 1 A, par exemple de plus de 5 A, voire de plus de 50 A. Une telle association correspond à un transistor composé des transistors élémentaires T110 et/ou T112.

Ainsi, le transistor composé des transistors élémentaires T110 et/ou T112 permet le passage de courants élevés, et permet, comme ceci a été mentionné, d'améliorer le compromis entre la tension maximum bloquée et la résistance à l'état passant.

Les figures 3 et 4 illustrent, de manière partielle et schématique, des étapes d'un exemple de procédé de fabrication du dispositif 100 de la figure 1. Plus précisément, la figure 3 représente une vue de dessus 3A, et des vues en coupe 3B, 3C, 3D et 3E à une même étape, et la figure 4 représente une vue de dessus 4A et des vues en coupe 4B, 4C, 4D et 4E à une autre étape. Les plans de coupe sont respectivement les mêmes que ceux de la figure 1.

A l'étape de la figure 3, on prévoit le substrat 102. Optionnellement, on forme le caisson enterré 220, sous la région 180. Le caisson enterré 220 peut être formé à cette étape ou à une étape ultérieure du procédé.

On grave ensuite les tranchées 160, 160A et 190 dans le substrat 102, de préférence jusqu'à un niveau situé moins profondément dans le substrat 102 que le caisson enterré 220. Après cela, on forme, sur les parois et le fond des tranchées, une couche électriquement isolante 310 dont des portions constitueront les futures régions isolantes 200 et 206, et les futures couches isolantes 172, 172A et 204 des tranchées respectives 160, 160A et 190. A titre d'exemple, la couche 310 est obtenue par un dépôt conforme recouvrant la structure résultant de la gravure des tranchées. La couche isolante 310 est de préférence en oxyde de silicium ou en nitrure de silicium. L'épaisseur de la couche isolante 310 est inférieure à la demi-largeur des tranchées, en sorte de laisser un espace non rempli en partie centrale des tranchées.

Ensuite, on remplit l'espace restant des tranchées, de préférence par du silicium polycristallin dopé. Il en résulte les éléments conducteurs 170, 170A et 210 situés dans les tranchées respectives. A titre d'exemple, on recouvre de silicium polycristallin l'ensemble de la structure résultant du dépôt de la couche isolante 310, et on retire par gravure le silicium polycristallin situé au-dessus d'un niveau donné. Ce niveau donné est préférentiellement celui de la face avant 104 du substrat 102, ou est situé à une hauteur inférieure à 10 nm au-dessus de la face avant 104 du substrat 102.

A l'étape de la figure 4, à un emplacement 420 de la grille 120 et de l'isolant de grille 122, on retire les portions de la couche isolante 310 et du matériau conducteur du deuxième élément conducteur 210. De préférence, pour cela, on a préalablement formé un masque 460 (représenté en pointillés) laissant accessible une partie 464 de la face supérieure de la structure. De préférence, la partie 464 a en vue de dessus une forme de bande dont la direction principale, ou direction d'allongement, est orthogonale à la direction de longueur des tranchées. Les portions du matériau conducteur du deuxième élément conducteur 210 situées dans la bande 464 sont gravées, sélectivement par rapport à la couche isolante 310, jusqu'au niveau supérieur de la partie de l'élément conducteur 210 située sous la grille 120. La couche isolante 310 protège le substrat 102 au cours de la gravure du matériau conducteur du deuxième élément conducteur 210. Ensuite, les portions de la couche isolante 310 accessibles, notamment celles qui ont été rendues accessibles par la gravure du matériau conducteur de l'élément conducteur 210, sont gravées sélectivement par rapport au substrat 102.

A une étape ultérieure, non représentée, on forme l'isolant de grille 122 sur les parois de la deuxième tranchée 190 accessibles dans la bande 464. On forme, de préférence simultanément avec l'isolant de grille 122, l'isolant 212 destiné à isoler le deuxième élément conducteur 210 de la future grille 120. Ceci peut être obtenu par une oxydation thermique. On forme ensuite la grille 120. Les régions dopées 140, 142, 150 et 152 peuvent être formées par dopage du substrat 102 avant ou après les étapes décrites ci-dessus.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en œuvre pratique des modes de réalisation et variantes décrits est à la portée de l'homme du métier à partir des indications fonctionnelles données ci-dessus.

## Revendications

1. Transistor (T110) comprenant une région semiconductrice de drain (140) délimitée par une première tranchée (160, 160A), et, dans la première tranchée, un premier élément électriquement conducteur (170, 170A) relié électriquement à un nœud (145) d'application d'un potentiel plus proche d'un potentiel de drain du transistor que d'un potentiel de source du transistor.

2. Transistor (T110) selon la revendication 1, comprenant une grille (120) située dans une deuxième tranchée (190) colinéaire à la première tranchée (160).

3. Transistor (T110) selon la revendication 2, comprenant, entre la grille (120) et le premier élément conducteur, une région isolante (200) d'épaisseur supérieure à une épaisseur d'isolant de grille (122) du transistor (T110) et, de préférence, une partie (202) de la région semiconductrice de drain (140).

4. Transistor (T110) selon la revendication 2 ou 3, comprenant un deuxième élément conducteur (210) situé dans la deuxième tranchée (190).

5. Transistor (T110) selon l'une quelconque des revendications 1 à 4, dans lequel la première tranchée (160, 160A) s'étend dans un substrat (102) à partir d'une face (104) du substrat, une prise de contact de drain (142) du transistor et une zone de formation de canal (130) du transistor étant situées du côté de ladite face du substrat.

6. Transistor (T110) selon la revendication 5, dans lequel la zone de formation de canal (130) est reliée électriquement à un nœud (155) d'application du potentiel de source du transistor.

7. Transistor selon la revendication 5 ou 6 dans sa dépendance à la revendication 2, comprenant une région semiconductrice de source (150), délimitée par la deuxième tranchée (190) et en contact avec la zone de formation de canal (130) du côté de la zone de formation de canal (130) opposé à la région semiconductrice de drain (140).

8. Transistor selon l'une quelconque des revendications 5 à 7, dans lequel la première tranchée (160, 160A) s'étend dans une région du substrat (180) située en partie sous la région semiconductrice de drain (140).

9. Transistor selon la revendication 8, dans lequel la zone de formation de canal (130) est une partie de ladite région du substrat (180).

10. Transistor selon la revendication 8 ou 9, dans lequel ladite région du substrat (180) est isolée, par un caisson enterré (220), d'une autre région du substrat située sous le caisson enterré, le caisson enterré étant de préférence entièrement situé à une profondeur supérieure à celle du fond de la première tranchée (160, 160A).

11. Transistor selon l'une quelconque des revendications 1 à 10, dans lequel la région semiconductrice de drain (140) est délimitée, d'un côté opposé à celui de la première tranchée (160), par une tranchée supplémentaire (160A), et un élément électriquement conducteur supplémentaire (170A) est situé dans la tranchée supplémentaire.

12. Transistor selon la revendication 11, dans lequel des extrémités de la première tranchée et de la tranchée supplémentaire sont alignées dans une direction de largeur des tranchées.

13. Transistor selon l'une quelconque des revendications 1 à 12, dans lequel ladite région semiconductrice de drain (140) présente, dans une direction parallèle à la première tranchée (160), un niveau de dopage décroissant à partir de la prise de contact (142).

14. Dispositif électronique (100) comprenant un ou plusieurs transistors (T110, T112) selon l'une quelconque des revendications 1 à 13.

15. Dispositif (100) selon la revendication 14, monolithique et comprenant en outre des transistors de type CMOS et/ou un transistor vertical comprenant des tranchées de même profondeur que la première tranchée (160).
